# EUROPEAN PATENT APPLICATION

(11) **EP 4 756 803 A1**
(43) Date of publication of application: **10.06.2026**
(21) Application number: 25214720.2
(22) Date of filing: 10.11.2025
(51) Int. Cl.: G11C 5/02, G11C 5/04, H10W 90/00

(54) **MEMORY DEVICE AND SYSTEM INCLUDING TIERED MEMORY STRUCTURE**

(30) Priority: 05.12.2024 KR 20240179699
(71) Applicant: Samsung Electronics Co., Ltd., Suwon-si, Gyeonggi-do 16677 (KR)
(72) Inventor: CHANG, Joonyoung, 16677 Suwon-si (KR); PARK, Sungcheol, 16677 Suwon-si (KR); SEO, Youngduke, 16677 Suwon-si (KR); JANG, Taehong, 16677 Suwon-si (KR)
(74) Representative: Marks & Clerk LLP

(57) **Abstract**

A memory device may include a memory die stack including a plurality of memory dies stacked thereon, and a base die under the memory die stack. The base die may include a via interface circuit connected to the memory die stack; a die-to-die (D2D) interface circuit connected to a processor; a memory interface circuit connected to an external memory device; and a memory management circuit configured to control data migration between the memory die stack and the external memory device, based on access information related to first data stored in the memory die stack, determine whether to migrate the first data from the memory die stack to the external memory device, and based on an access request from the processor to access second data stored on the external memory device, provide the second data to the processor.

## Description

### BACKGROUND

One or more embodiments of the present disclosure relate to a memory device and a system including the memory device, and more particularly, to a memory device having a tiered memory structure and a system including the memory device.

With the continuous development of artificial intelligence (AI) systems, the demand for semiconductor chips with high performance and large-capacity data processing capability is increasing. Because an enormous amount of data needs to be processed to implement an AI system, it is very important to secure high computation performance as well as memory bandwidths and capacity to support the high computation performance.

High bandwidth memory (HBM) is a memory technology developed to satisfy growing demands for high data transmission speed and low power consumption, which is achieved by using vertically stacking multiple memory dies using three-dimensional (3D) stacking technology and connecting the memory dies using through vias such as through-silicon vias (TSVs). HBM may be utilized in graphics processing units (GPUs), AI accelerators, or the like to perform well in computationally intensive and data-centric systems. However, HBMs has relatively limited capacity and a higher cost per unit of storage compared to memory used in conventional general-purpose systems.

In general-purpose systems, for example, double data rate (DDR) dynamic random access memory (RAM) (DRAM) (DDR DRAM) may be used. The DDR DRAM may be widely used in systems, such as personal computers (PCs), servers, and workstations, and is characterized by lower bandwidth, but provides higher capacity and more economic efficiency than the HBM.

### SUMMARY

One or more embodiments provide a method of increasing data transmission bandwidth and at the same time, achieving high memory capacity and/or economic efficiency in a memory device and a system. One or more embodiments provide a memory device and system having increased data transmission bandwidth, high memory capacity, and/or economic efficiency.

According to an aspect of the disclosure, a memory device may include: a memory die stack including a plurality of memory dies stacked thereon; and a base die under the memory die stack. The base die may include: a via interface circuit including a plurality of through vias and connected to the memory die stack; a die-to-die (D2D) interface circuit connected to a processor; a memory interface circuit connected to an external memory device; and a memory management circuit configured to control data migration between the memory die stack and the external memory device, based on access information related to first data stored in the memory die stack, determine whether to migrate the first data from the memory die stack to the external memory device, and based on an access request from the processor to access second data stored on the external memory device, provide the second data to the processor. At least a portion of the memory die stack may overlay at least a portion of the base die in, for example, a vertical direction, e.g., the Z-axis.

According to an aspect of the disclosure, a system may include a first memory device including a first memory die stack configured to store first data and a first base die; a second memory device including a second memory die stack configured to store second data and a second base die; a third memory device configured to store third data and connected to the first base die; and a logic die including a host processor, connected to the first base die, and configured to generate an access request related to the first data, the second data, and the third data. The first base die may include: a via interface circuit connected to the first memory die stack; a first die-to-die (D2D) interface circuit connected to the logic die; a second D2D interface circuit connected to the second base die; a memory interface circuit connected to the third memory device; and a memory management circuit configured to control data migration among the first memory die stack, the second memory die stack, and the third memory device. The first D2D interface circuit may be connected to the host processor. The memory management circuit may be configured to control data migration between the first memory die stack and the third memory device. The memory management circuit may be configured to, based on access information related to first data stored in the first memory die stack, determine whether to migrate the first data from the memory die stack first to the third memory device. The memory management circuit may be configured to, based on an access request from the host processor to access second data stored on the third memory device, provide the second data to the host processor. The first memory device may comprise the described memory device of the earlier aspect. The third memory device may comprise the described external memory device of the earlier aspect.

According to an aspect of the disclosure, a system may include: a logic die including a host processor; a first memory device including a memory die stack including a plurality of memory dies stacked thereon, and a base die under the memory die stack and connected to the logic die; and a second memory device connected to the base die. The base die may include: a via interface circuit connected to the memory die stack; a die-to-die (D2D) interface circuit connected to the logic die; a memory interface circuit connected to the second memory device; and a memory management circuit configured to control data migration between the memory die stack and an external memory device, based on access information related to first data stored in the memory die stack, migrate the first data stored in the memory die stack to the second memory device, and based on an access request from the logic die to access second data stored in the second memory device, migrate the second data to the memory die stack. At least a portion of the memory die stack may overlay at least a portion of the base die in, for example, a vertical direction, e.g., the Z-axis.

At least some of the above and other features of the disclosure are set out in the claims.

### BRIEF DESCRIPTION OF DRAWINGS

Embodiments will be more clearly understood from the following detailed description taken in conjunction with the accompanying drawings in which:
FIG. 1 is a diagram of a system according to one or more embodiments;
FIG. 2 is a diagram of a first memory device according to one or more embodiments;
FIG. 3 is a diagram of a first memory device according to one or more embodiments;
FIG. 4 is a diagram of a system according to one or more embodiments;
FIG. 5 is a diagram of a base die according to one or more embodiments;
FIG. 6 is a diagram of a base die according to one or more embodiments;
FIG. 7 is a diagram of a base die according to one or more embodiments;
FIG. 8 is a diagram of a system according to one or more embodiments;
FIG. 9 is a diagram of a system according to one or more embodiments;
FIG. 10 is a diagram of a system according to one or more embodiments; and
FIG. 11 is a diagram of a system according to one or more embodiments.

### DETAILED DESCRIPTION OF EMBODIMENTS

Hereinafter, embodiments of the inventive concept are described in detail with reference to the accompanying drawings. When descriptions are given with reference to drawings, identical or corresponding components may be given with identical drawing reference numbers, and duplicate descriptions thereof are omitted.

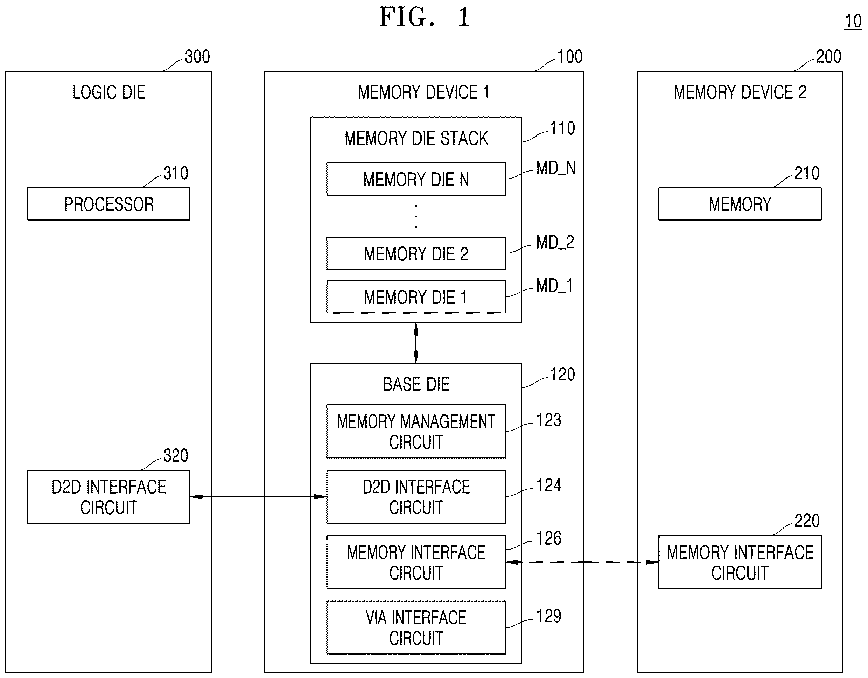

FIG. 1 is a diagram of a system 10 according to one or more embodiments.

Referring to FIG. 1, the system 10 may include a first memory device 100, a second memory device 200, and a logic die 300.

The first memory device 100 may include a memory die stack 110 and a base die 120. In the embodiment, the first memory device 100 may include a three-dimensionally (3D)-stacked memory or 3D-stacked DRAM including a plurality of memory dies that are vertically stacked and connected using one or more through vias such as through-silicon vias (TSVs). For example, the first memory device 100 may include a high bandwidth memory (HBM) including a plurality of stacked memory dies. In some embodiments, the first memory device 100 may be referred to as a 3D-stacked memory, a 3D-stacked DRAM, or a custom HBM.

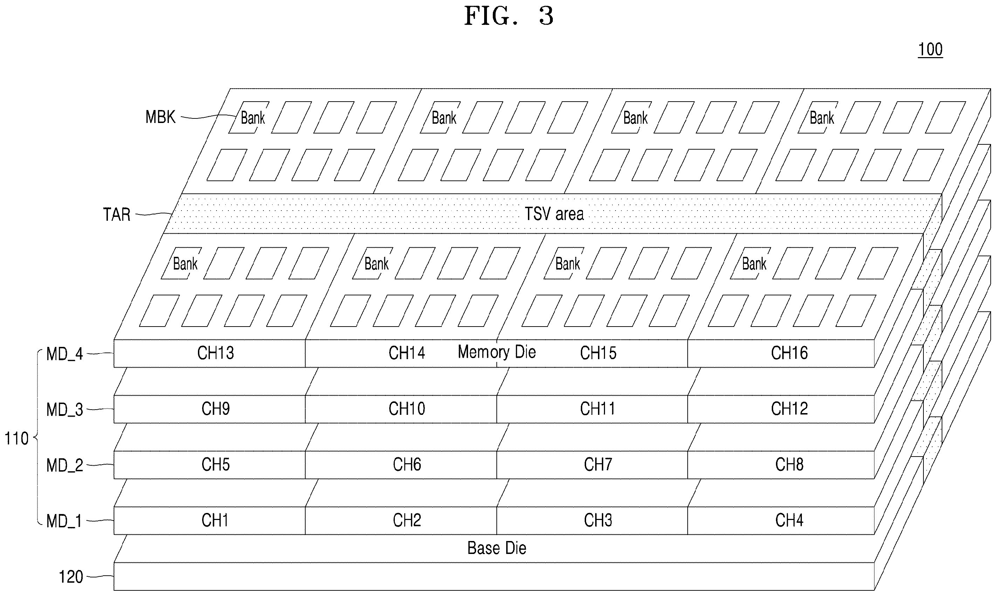

The memory die stack 110 may include first through N^{th} memory dies MD_1 through MD_N (N is a natural number equal to or greater than 2). The memory die stack 110 may include multiple channels (e.g., multiple channels CH1 through CH16 in FIG. 3) including independent interfaces from each other. When each of first channel CH1 through sixteenth channel CH16 has a bandwidth of 64 bits, the first memory device 100 may include components for 1024-bit data input/output. In some embodiments, each of the multiple memory dies may be referred to as a core die.

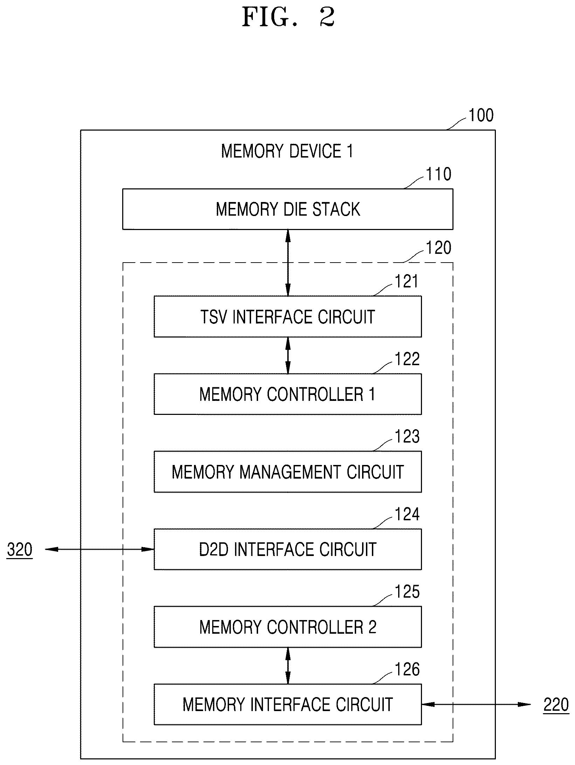

The base die 120 may include a memory management circuit 123, a die-to-die (D2D) interface circuit 124, a memory interface circuit 126, and a via interface circuit 129. In some embodiments, the base die 120 may be referred to as a buffer die or a bottom die. Other components included in the base die 120 is described below with reference to FIG. 2. In some embodiments, the via interface circuit 129 may be configured to provide an electrical connection between the base die 120 and the memory die stack 110. In some embodiments, the via interface circuit 129 may comprise, for example, a through-silicon via (TSV) interface circuit.

The memory management circuit 123 may control data migration between the first memory device 100 and the second memory device 200. The second memory device 200 may include be a two-dimensional (2D) memory in terms of physical layout, such as double data rate (DDR) DRAM, lower power double data rate (LPDDR) DRAM, or graphics double data rate (GDDR) DRAM. In these types of memory, memory chips are laid out horizontally on a substrate, and data communication occur across the surface through pins or solder balls, and without vertical stacking of memory dies. For example, the memory management circuit 123 may control data migration between a 3D-stacked memory and a 2D memory.

By including a D2D interface circuit 320 and providing a request signal to the first memory device 100, the logic die 300 may access the first memory device 100 to write data or read data. When the request signal is received from the logic die 300 by the first memory device 100, the memory management circuit 123 may store access information corresponding to the request signal. In the present disclosure, "memory access" or "memory access operations" refers to operations that include reading data from or writing data to memory.

In one or more embodiments, the logic die 300 may be located outside the first memory device 100, and may include a component differentiated from the base die 120. In other words, the logic die 300 and the base die 120 may be manufactured by using different dies. The logic die 300 may be referred to as a semiconductor die that contains logic circuitry performing logic operations requiring enormous amount of data (e.g., training of an artificial intelligence (AI) model, inference by using the AI model, or the like) by writing data to the first memory device 100 and the second memory device 200, or reading data stored in the first memory device 100 and the second memory device 200. In some embodiments, the logic die 300 may be referred to as a calculation device, a processor die (e.g., including a general-purpose processor) or an application specific integrated circuit (ASIC) die.

In one or more embodiments, the request signal may be referred to as a signal including at least one of a command signal, an address signal, and a data signal for a write operation and a read operation on and from the first memory device 100 and the second memory device 200.

In the embodiment, the access information may include information indicating a time point at which the request signal provided by the logic die 300 is received by the first memory device 100.

In the embodiment, when the logic die 300 provides to the first memory device 100 the request signal for accessing first data stored in the memory die stack 110 of the first memory device 100, the base die 120 of the first memory device 100 may perform an operation indicated by the request signal (e.g., write or read) on the memory die stack 110 in response to the request signal. In response to the access, the memory management circuit 123 may record an access time associated with the first data accessed by the logic die 300. The memory management circuit 123 may continuously monitor an access elapse time, which presents a duration since the most recent access by the logic die 300 to the first data. When the access elapse time is equal to or greater than a migration reference value (e.g., a predetermined migration threshold), the memory management circuit 123 may determine that the first data is to be migrated from the first memory device 100 to the second memory device 200. The first memory device 100, which may be implemented using high-bandwidth memory (HBM), is suitable for storing data with high access frequency, such as frequently used intermediate results or model parameters in AI computations generated by the logic die 300. The second memory device 200, which may be implemented using a two-dimensional memory architecture such as DDR, LPDDR, or GDDR, may store data with lower access frequency due to its larger capacity and lower cost-per-bit.

In the embodiment, the migration reference value may include a value that has been pre-set and stored in the memory management circuit 123.

In the embodiment, when the logic die 300 provides to the first memory device 100 the request signal for accessing second data stored in a memory 210 of the second memory device 200, the base die 120 of the first memory device 100 may perform an operation indicated by the request signal (e.g., write or read) on the memory 210 of the second memory device 200 in response to the request signal. In response to the access, the memory management circuit 123 may analyze an access pattern and may determine whether the second data should be migrated from the second memory device 200 to the first memory device 100. The migration decision may be based on factors such as increased access frequency, latency sensitivity, or performance optimization for compute-intensive tasks being executed by the logic die 300. Based on the migration decision, the memory management circuit 123 may determine that the second data is to be migrated to the first memory device 100.

The first memory device 100 and the logic die 300 may be interconnected via D2D interfaces, and may perform communication. The D2D interface circuit 124 may be electrically connected to a processor, e.g., processor 310 of logic die 300. The D2D interface circuit 124 may be electrically connected to a processor (e.g., processor 310 of logic die 300) via connection to the D2D interface circuit 320 of the logic die 300. The D2D interface circuit 124 and the D2D interface circuit 320 may include physical or electrical layers and logical layers, which are provided for signals, frequencies, timings, driving, detailed operation parameters, and functionality required for efficient communication between the first memory device 100 and the logic die 300.

In the embodiment, the D2D interface circuit 320 of the logic die 300 and the D2D interface circuit 124 of the base die 120 may operate based on peripheral component interconnect express (PCIe) or universal chip interconnect express (UCIe) standard specification in performing communication between the logic die 300 and the base die 120.

The first memory device 100 and the second memory device 200 may be interconnected via an interface based on the Joint Electron Device Engineering Council (JEDEC) standard specification, and may perform communication. The memory interface circuit 126 may be electrically connected to the second memory device 200. The memory interface circuit 126 may be electrically connected to a memory interface circuit 220 of the second memory device 200. The memory interface circuit 126 and the memory interface circuit 220 may include physical or electrical layers and logical layers, which are provided for signals, frequencies, timings, driving, detailed operation parameters, and functionality required for efficient communication between the first memory device 100 and the second memory device 200.

In the embodiment, the memory interface circuit 220 of the second memory device 200 and the memory interface circuit 126 of the base die 120 may operate via an interface satisfying the JEDEC standard specifications, such as double data rate (DDR), low power (LP) DDR (LPDDR), and graphics (G) DDR (GDDR) in performing communication between the second memory device 200 and the base die 120.

In the embodiment, the interface between the first memory device 100 and the logic die 300 may include a non-JEDEC interface not satisfying the JEDEC standard specification, and the interface between the first memory device 100 and the second memory device 200 may include an interface satisfying the JEDEC standard specification.

The logic die 300 may include a processor 310 and the D2D interface circuit 320. In some embodiments, the logic die 300 may be referred to as a host or a system on chip (SoC).

The processor 310 may execute applications supported by the system 10 by using the first memory device 100 and the second memory device 200. To execute the applications, the processor 310 may provide the request signal to the first memory device 100 and the second memory device 200 to access the first memory device 100 and the second memory device 200.

The processor 310 may be configured to execute one or more machine-executable instructions or pieces of software, firmware, or a combination thereof. For example, the processor 310 may include a central processing unit (CPU), a digital signal processor (DSP), a graphics processing unit (GPU), a neural processing unit (NPU), an application processor (AP), a communication processor (CP), an encryption processing unit, a physics processing unit, a machine learning processing unit, etc.

The first memory device 100 may have a relatively greater bandwidth than the second memory device 200 in transceiving data to and from the logic die 300. Memory capacity of the first memory device 100 may be less than that of the second memory device 200. In one or more embodiments, the first memory device 100 may be configured as a first-tier memory, and the second memory device 200 may be configured as a second-tier memory. The system 10 may have a tiered memory architecture, where memory devices are organized into hierarchical levels based on performance characteristics such as bandwidth, latency, and capacity. In this tiered structure, data (e.g., model weights, intermediate feature maps, time-critical parameters) that is frequently accessed by the logic die 300 may be stored in the first memory device 100, and data not frequently accessed by the logic die 300 may be stored in the second memory device 200. A system according to the embodiment may secure high memory capacity while maintaining a high bandwidth related to data transmission by using a tiered memory structure.

FIG. 2 is a diagram of the first memory device 100 according to one or more embodiments. FIG. 2 may be described with reference to FIG. 1, and duplicate descriptions thereof are omitted.

Referring to FIG. 2, the first memory device 100 may include the memory die stack 110 and the base die 120.

The base die 120 ma include a via interface circuit, e.g., a through-silicon via (TSV) interface circuit 121, a first memory controller 122, the memory management circuit 123, the D2D interface circuit 124, a second memory controller 125, and the memory interface circuit 126.

The TSV interface circuit 121 may be electrically connected to a plurality of TSVs penetrating the memory die stack 110 in a vertical direction. The base die 120 may perform an input/output operation on the data stored in the memory die stack 110 by using the TSV interface circuit 121.

By accessing the memory die stack 110 via the TSV interface circuit 121, based on the request signal provided by the logic die 300, the first memory controller 122 may write data to the memory die stack 110 or read data stored in the memory die stack 110. In some embodiments, the first memory controller 122 may be referred to as an HBM controller.

By accessing the second memory device 200 via the memory interface circuit 220, based on the request signal provided by the logic die 300, the second memory controller 125 may write data to the memory 210 of the second memory device 200 or read data stored in the memory 210. In some embodiments, the second memory controller 125 may be referred to as a 2D memory controller.

FIG. 3 is a diagram of the first memory device 100 according to one or more embodiments.

Referring to FIG. 3, the first memory device 100 may include an HBM including first through sixteenth channels CH1 through CH16 having access independent interfaces of each other. The first memory device 100 may include a plurality of memory dies, and for example, may include the memory die stack 110 and the base die 120. The memory die stack 110 may be stacked on the base die 120. At least a portion of the memory die stack 110 may overlay at least a portion of the base die 120. The memory die stack 110 may be stacked or overlay the base die 120 in a vertical or Z-axis direction.

The memory die stack 110 may include four memory dies MD1 through MD4, and the memory dies MD1 through MD4 may support sixteen of first through sixteenth channels CH1 through CH16. In some embodiments, a memory die constituting the memory die stack 110 may be referred to as a DRAM die. In the present embodiment, although the first memory device 100 is illustrated to include the four the memory dies MD_1 through MD_4, it is not limited thereto, and eight, twelve, sixteen, or more memory dies may be stacked.

The first memory die MD_1 may include the first through fourth channels CH1 through CH4, the second memory die MD_2 may include the fifth through eighth channels CH5 through CH8, the third memory die MD_3 may include the ninth through twelfth channels CH9 through CH12, and the fourth memory die MD_4 may include the thirteenth through sixteenth channels CH13 through CH16. When each of the firth through sixteenth channels CH1 through CH16 supports 64 data transfer paths (that is, when there are 64 data signal pins corresponding to each of the firth through sixteenth channels CH1 through CH16), the first memory device 100 including 16 channels, that is, the firth through sixteenth channels CH1 through CH16 may support 1024 data transfer paths (that is, the bandwidth has 1024 bits). However, the embodiment is not limited thereto, the first memory device 100 may support 1024 or more data transfer paths, and support various number of channels (e.g., 8 channels). For example, when the first memory device 100 supports 8 channels, and each channel supports 128 data transfer paths, the first memory device 100 may support 1024 data transfer paths.

Each of the firth through sixteenth channels CH1 through CH16 may include a plurality of memory banks MBK. Each of the memory banks MBK may include memory cells connected to word lines and bit lines.

In one or more embodiments, one channel may be divided into two pseudo channels operating independently. For example, the pseudo channels may share a command of a channel, but may decode and execute the command independently. For example, when one channel supports 64 data transfer paths, each of the pseudo channels may support 32 data transfer paths. For example, when one channel includes 32 memory banks MBK, each of the pseudo channels may include 16 memory banks MBK.

The base die 120 and the memory dies MD_1 through MD_4 may include a TSV area TAR. In the TSV area TAR, TSVs are configured to penetrate the memory dies MD_1 through MD_4 in a vertical direction. The base die 120 may transceive various signals by being electrically connected to the memory dies MD_1 through MD_4 via the TSVs. Each of the memory dies MD_1 through MD_4 may transceive signals to and from the base die 120 and other memory dies via the TSVs. In this case, the signals may be transceived independently via the TSVs corresponding to each channel. For example, when the logic die 300 transmits the data signal to the first channel CH1 to store data in a memory cell of the first channel CH1, the base die 120 may transmit the data signal to the first memory die MD_1 via the TSVs corresponding to the first channel CH1. Accordingly, data may be stored in the memory cell of the first channel CH1.

The base die 120 may communicate with conductive components formed outside the first memory device 100, for example, bumps or solder balls. The base die 120 may receive the request signal from the logic die 300, and by accessing a channel constituting the memory die stack 110 based on a command, an address, and data representing the received request signal, may perform an operation directed by the request signal.

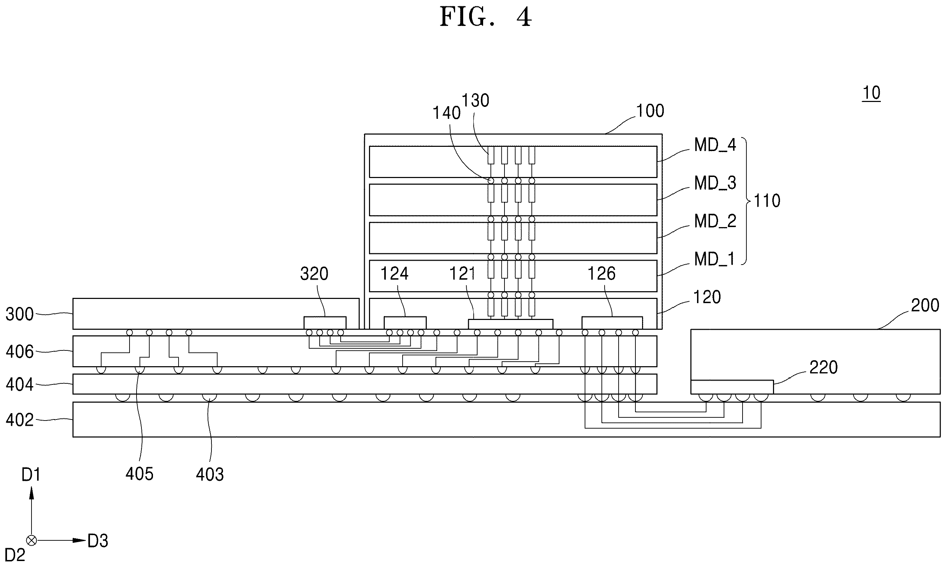

FIG. 4 is a diagram of the system 10 according to one or more embodiments. FIG. 4 may be described with reference to FIGS. 1 through 3, and duplicate descriptions thereof may be omitted.

Referring to FIG. 4, the system 10 may include the first memory device 100, the second memory device 200, the logic die 300, a first substrate 402, a second substrate 404, and an interposer 406. The first memory device 100 may include a memory die stack 110 and a base die 120. In one or more embodiments, a direction perpendicular to the first substrate 402, the second substrate 404, and the interposer 406 may be referred to as a first direction D1 or vertical direction (e.g., the Z-axis), a direction perpendicular to the first direction D1 may be referred to as a second direction D2 or a first horizontal direction (e.g., the X-axis), and a direction perpendicular to the first direction D1 and the second direction D2 may be referred to as a third direction D3 or a second horizontal direction (e.g., the Y-axis).

The memory die stack 110 may include the first through fourth memory dies MD_1 through MD_4. The first through fourth memory dies MD_1 through MD_4 may include TSVs 130 penetrating in the first direction D1 that is the direction perpendicular to the first substrate 402. Between each of the first through fourth memory dies MD_1 through MD_4, bumps 140 which are conductive swellings capable of electrically connecting the memory dies.

Bumps 405 may be attached to an upper portion of the second substrate 404, and solder balls 403 may be attached to a lower portion of the second substrate 404. For example, the bumps 405 may include flip-chip bumps. The interposer 406 may be stacked on the second substrate 404 by using the bumps 405.

In the embodiment, the first substrate 402 may include a printed circuit board (PCB). The second substrate 404 may include a package substrate.

In the embodiment, the second substrate 404 and components arranged on the second substrate 404 may constitute one semiconductor package. The semiconductor package may transceive signals to and from external other packages or external semiconductor devices.

The interposer 406 may buffer circuit line width differences between the base die 120 and the second substrate 404. The interposer 406 may include an electrical interface that routes connections to one socket or another socket, to extend electrical wiring to a wider pitch or reroute the electrical wiring to a different pitch. The interposer 406 may physically connect the base die 120 and the logic die 300 to the second substrate 404. The first memory device 100 may transceive signals to and from the logic die 300 via wirings arranged in the interposer 406.

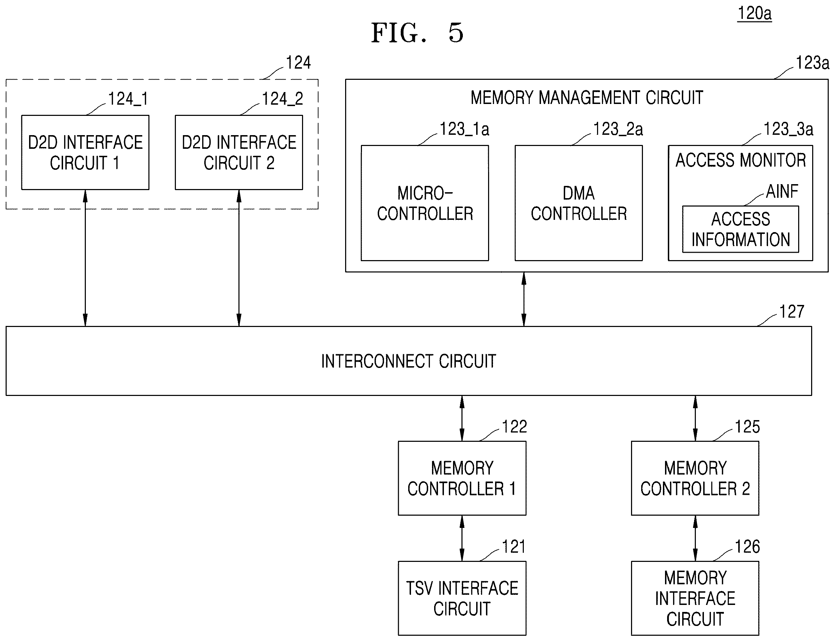

FIG. 5 is a diagram of a base die 120a according to one or more embodiments. FIG. 5 may be described with reference to FIGS. 1 and 2, and duplicate descriptions thereof may be omitted.

Referring to FIG. 5, the base die 120a of FIG. 5 may correspond to the base die 120 in FIG. 1.

The base die 120a may include the TSV interface circuit 121, the first memory controller 122, a memory management circuit 123a, the D2D interface circuit 124, the second memory controller 125, the memory interface circuit 126, and an interconnect circuit 127.

In FIG. 5, the base die 120a is illustrated to include each one of the TSV interface circuit 121, the first memory controller 122, the second memory controller 125, and the memory interface circuit 126, but this is an example only for description, and more circuits (e.g., four memory controllers 122 and four memory controllers 125) may be included.

FIG. 5 illustrates that the D2D interface circuit 124 includes one first D2D interface circuit 124_1 and one second D2D interface circuit 124_2, but this is only an example for description, and the D2D interface circuit 124 may include more circuits (e.g., two first D2D interface circuits 124_1 and two second D2D interface circuits 124_2).

FIG. 5 illustrates that the memory management circuit 123a includes one direct memory access (DMA) controller 123_2a, but this is only an example for description, and the memory management circuit 123a may include more circuits (e.g., four DMA controllers 123_2a).

The memory management circuit 123a may include a microcontroller 123_1a, the DMA controller 123_2a, and an access monitor 123_3a.

The memory management circuit 123a may process requests received by the base die 120a via the microcontroller 123_1a. In addition, the memory management circuit 123a may control the DMA controller 123_2a by using the microcontroller 123_1a. By controlling the DMA controller 123_2a based on access information AINF stored in the access monitor 123_3a, the memory management circuit 123a may control the DMA controller 123_2a to perform a data migration operation and a data prefetch operation between the first memory device 100 and the second memory device 200.

In the embodiment, the microcontroller 123_1a may include a microcontroller unit (MCU), a central processing unit (CPU), or a graphics processing unit (GPU).

In one or more embodiments, the DMA controller 123_2a may be referred to as hardware independently performing data transmission performed with respect to the memory die stack 110 or the memory 210.

The access monitor 123_3a may store the access information AINF related to memory operations performed by the logic die 300. The access monitor 123_3a may monitor data signals that are input and output via the TSV interface circuit 121 and the memory interface circuit 126.

In the embodiment, when the logic die 300 accesses the first data stored in the memory die stack 110 of the first memory device 100, the access monitor 123_3a may log or store the access information AINF indicating a memory address and an access time point of the first data. In addition, the access monitor 123_3a may monitor or track an elapsed time since the last access to the first data by the logic die 300. When the access elapse time indicating an elapse time after accessing the first data lastly is equal to or greater than the migration reference value, the access monitor 123_3a may determine migration of the first data. When the access monitor 123_3a determines the migration of the first data, the memory management circuit 123a may migrate the first data from the memory die stack 110 (e.g., first-tier memory) of the first memory device 100 to the memory 210 (e.g., second-tier memory) of the second memory device 200.

In the embodiment, when the second data stored in the memory 210 has been accessed by the logic die 300, the access monitor 123_3a may determine migration of the second data. When the access monitor 123_3a determines the migration of the second data, the memory management circuit 123a may migrate the second data from the memory 210 of the second memory device 200 to the memory die stack 110 of the first memory device 100.

In the embodiment, the memory management circuit 123a may perform a prefetch operation on data anticipated to be used in the future.

In the embodiment, the access monitor 123_3a may be implemented in various forms and provided in the memory management circuit 123a. For example, the access monitor 123_3a may be implemented as hardware (HW) such as a logic circuit. In this case, the access monitor 123_3a may include a separate memory for storing the access information AINF. Alternatively, the access monitor 123_3a may be implemented as software (SW) including programs, or the access monitor 123_3a may be implemented as a combination of HW and SW.

The D2D interface circuit 124 may include a first D2D interface circuit 124_1 and a second D2D interface circuit 124_2. The first D2D interface circuit 124 _1 and the second D2D interface circuit 124_2 may be electrically connected to the interconnect circuit 127.

The first D2D interface circuit 124_1 may include a circuit performing communication between the logic die 300 and the base die 120 by electrically connecting the logic die 300 to the base die 120.

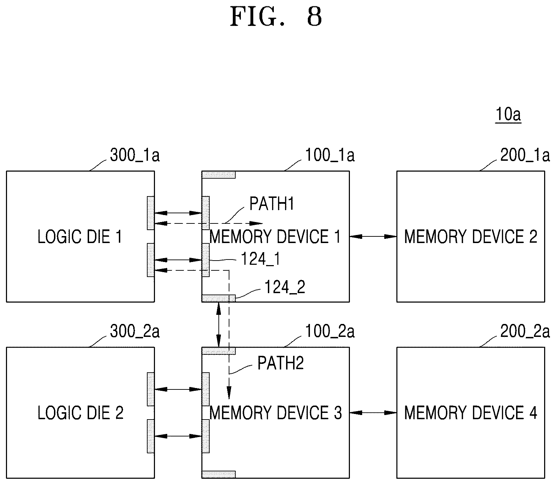

By electrically connecting the base die 120 to another base die, the second D2D interface circuit 124_2 may include a circuit performing communication between the first memory device 100 and a memory device having the same structure. The second D2D interface circuit 124_2 is described below with reference to FIG. 8.

The interconnect circuit 127 may be electrically connected to the first memory controller 122, the second memory controller 125, the D2D interface circuit 124, and the memory management circuit 123a. The interconnect circuit 127 may include a circuit providing communication between the first memory controller 122, the second memory controller 125, the D2D interface circuit 124, and the memory management circuit 123a.

In the embodiment, the interconnect circuit 127 may include a circuit having a network-on-chip (NoC) structure. As many IP blocks, such as several processor cores, memories, and periphery devices are designed in a block-to-block connection manner in an integrated system on chip SoC, the NoC may be referred to as a structure of an interconnect circuit supporting communication between various components.

In the embodiment, the interconnect circuit 127 may operate based on one of various bus protocols. The various bus protocol may include at least one of advanced microcontroller bus architecture (AMBA) protocol, universal serial bus (USB) protocol, multi-media card (MMC) protocol, peripheral component interconnection (PCI) protocol, PCI-express (E) PCI-E protocol, advanced technology attachment (ATA) protocol, serial (S) ATA (SATA) protocol, parallel (P) ATA (PATA) protocol, small computer system interface (SCSI) protocol, enhanced small disk interface (ESDI) protocol, integrated drive electronics (IDE) protocol, mobile industry processor interface (MIPI) protocol, universal flash storage (UFS) protocol, etc.

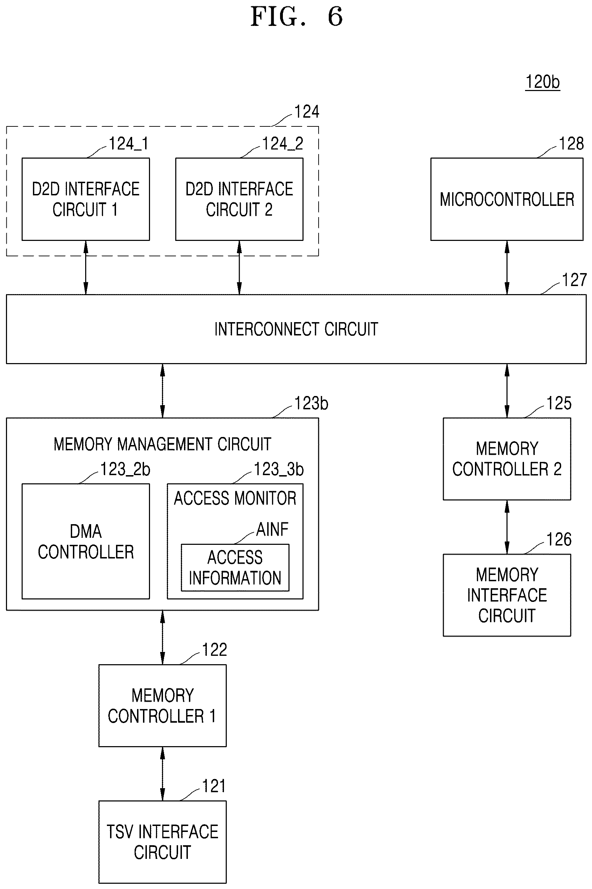

FIG. 6 is a diagram of a base die 120b according to one or more embodiments. FIG 6 may be a diagram of one or more embodiments in which a memory management circuit 123b is arranged between the interconnect circuit 127 and the first memory controller 122. FIG. 6 may be described with reference to FIGS. 1, 2, and 5, and duplicate descriptions thereof may be omitted.

Referring to FIG. 6, the base die 120b may correspond to the base die 120 in FIG. 1.

The base die 120b may include the TSV interface circuit 121, the first memory controller 122, a memory management circuit 123b, the D2D interface circuit 124, the second memory controller 125, the memory interface circuit 126, the interconnect circuit 127, and a microcontroller 128. Hereinafter, differences from FIG. 5 are mainly described.

The microcontroller 128 may correspond to the microcontroller 123_1a. The memory management circuit 123b may include a DMA controller 123_2b and an access monitor 123_3b. The DMA controller 123_2b may correspond to the DMA controller 123_2a in FIG. 5, and the access monitor 123_3b may correspond to the access monitor 123_3a in FIG. 5. The memory management circuit 123b may be electrically connected to the first memory controller 122.

The interconnect circuit 127 may be electrically connected to the memory management circuit 123b, the D2D interface circuit 124, the second memory controller 125, and the microcontroller 128.

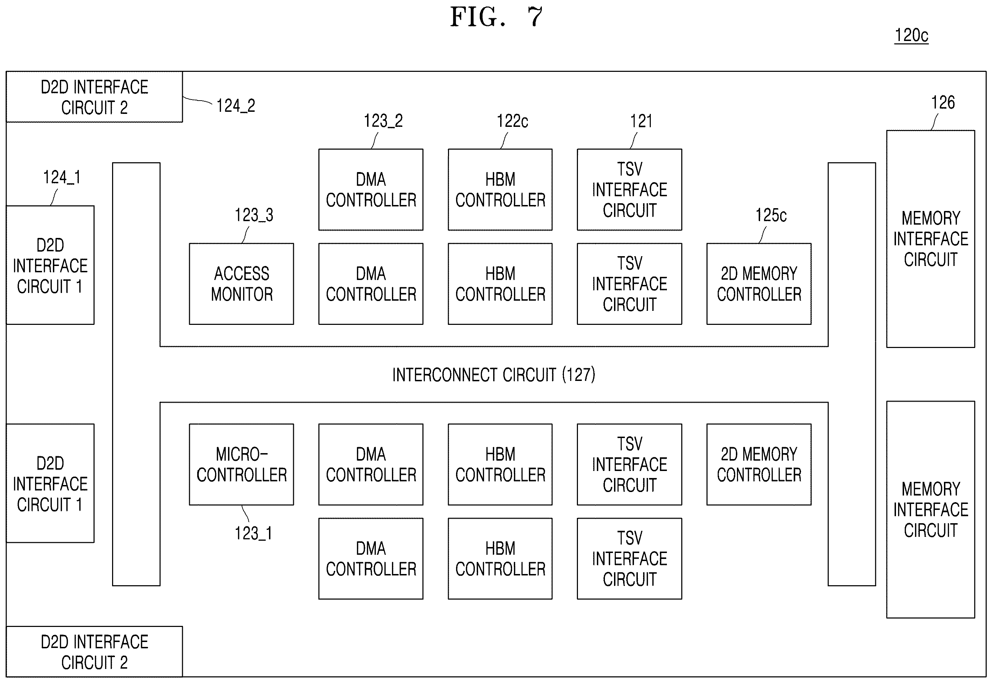

FIG. 7 is a diagram of a base die 120c according to one or more embodiments. FIG. 7 is a schematic diagram of arrangement of circuits constituting the base die 120c. FIG. 7 may be described with reference to FIG. 1 through 6, and duplicate descriptions thereof may be omitted.

Referring to FIG. 7, the base die 120c may correspond to the base die 120 in FIG. 1. The base die 120c may include the TSV interface circuit 121, an HBM controller 122c, a microcontroller 123_1, a DMA controller 123_2, an access monitor 123_3, the first D2D interface circuit 124_1, the second D2D interface circuit 124_2, a 2D memory controller 125c, the memory interface circuit 126, and the interconnect circuit 127.

FIG. 7 illustrates four of each of the TSV interface circuit 121, the HBM controller 122c, and the DMA controller 123_2, but this is an example for description, and the number may be greater than or less than four.

FIG. 7 illustrates two of each of the first D2D interface circuit 124_1, the second D2D interface circuit 124_2, and the 2D memory controller 125c, but this is an example for description, and the number may be greater than or less than two.

The HBM controller 122c may correspond to the first memory controller 122 in FIG. 2. The 2D memory controller 125c may correspond to the second memory controller 125 in FIG. 2.

The microcontroller 123_1 may correspond to the microcontroller 123_1a in FIG. 5 or the microcontroller 128 in FIG. 6. The DMA controller 123_2 may correspond to the DMA controller 123_2a in FIG. 5 or the DMA controller 123_2b in FIG. 6. The access monitor 123_3 may correspond to the access monitor 123_3a in FIG. 5 or the access monitor 123_3b in FIG. 6.

Components included in the base die 120c may be electrically connected to each other via the interconnect circuit 127.

The first D2D interface circuit 124_1 may include an interface circuit performing communication with the logic die 300, by being electrically connected to the logic die (300 in FIG. 1).

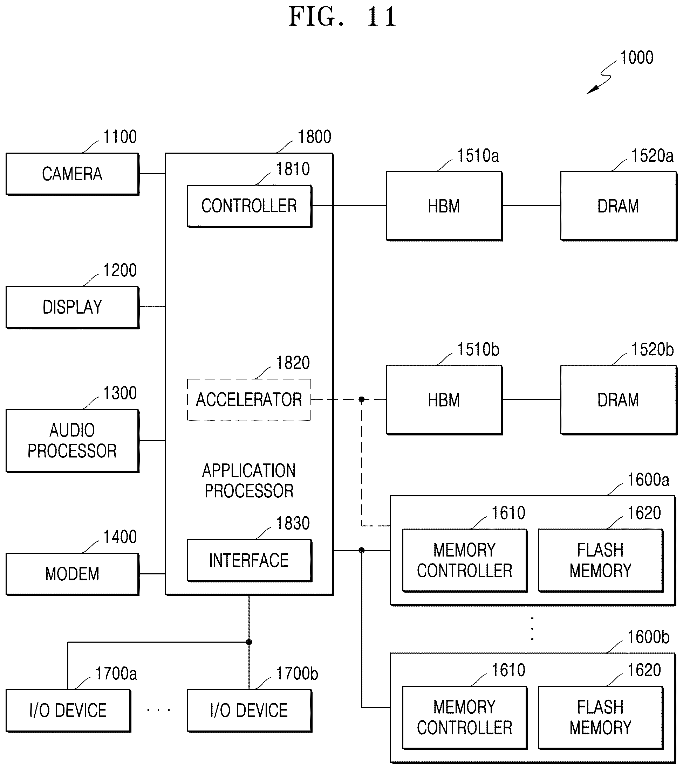

The second D2D interface circuit 124_2 may include an interface circuit performing communication with another base die, by being electrically connected to the other base die. In the embodiment, the first memory device 100 including the base die 120c may communicate with a third memory device having the same structure as the first memory device 100. In this case, the first memory device 100 may communicate with the third memory device via the second D2D interface circuit 124_2 of the base die 120c. This communication is described below with reference to FIG. 11.

The memory interface circuit 126 may include an interface circuit performing communication with the second memory device 200, by being electrically connected to the second memory device (200 in FIG. 1).

In the embodiment, the base die 120c may further include a test logic circuit including a logic for testing defects of the memory die stack 110.

FIG. 8 is a diagram of a system 10a according to one or more embodiments. FIG. 8 may be described with reference to FIG. 1 through 7, and duplicate descriptions thereof may be omitted.

Referring to FIG. 8, the system 10a may include a first logic die 300_1a, a second logic die 300_2a, a first memory device 100_1a, a second memory device 200_1a, a third memory device 100_2a, and a fourth memory device 200_2a.

Each of the first logic die 300_1a and the second logic die 300_2a may correspond to the logic die 300 in FIG. 1. Each of the first memory device 100_1a and the third memory device 100_2a may correspond to the first memory device 100 in FIG. 1. Each of the second memory device 200_1a and the fourth memory device 200_2a may correspond to the second memory device 200 in FIG. 1.

An interface circuit for communication between the first logic die 300_1a and the first memory device 100_1a may be the first D2D interface circuit 124_1. In one or more embodiments, the first D2D interface circuit 124_1 may be a D2D interface circuit for communication between a logic die and a memory device.

In the embodiment, when the first logic die 300_1a is required to access the first memory device 100_1a for writing or reading data, the first logic die 300_1a may access the first memory device 100_1a via the first D2D interface circuit 124_1. A first path PATH1 may indicate a path along which the first logic die 300_1a accesses the first memory device 100_1a.

An interface circuit for communication between the first memory device 100_1a and the third memory device 100_2a may be the second D2D interface circuit 124_2. In one or more embodiments, the second D2D interface circuit 124_2 may comprise a D2D interface circuit for communication between memory devices.

In the embodiment, when the first logic die 300_1a is required to access the third memory device 100_2a for writing or reading data, the first logic die 300_1a may access the third memory device 100_2a via the first D2D interface circuit 124_1 and the second D2D interface circuit 124_2. The second path PATH2 may indicate a path along which the first logic die 300_1a accesses the third memory device 100_2a.

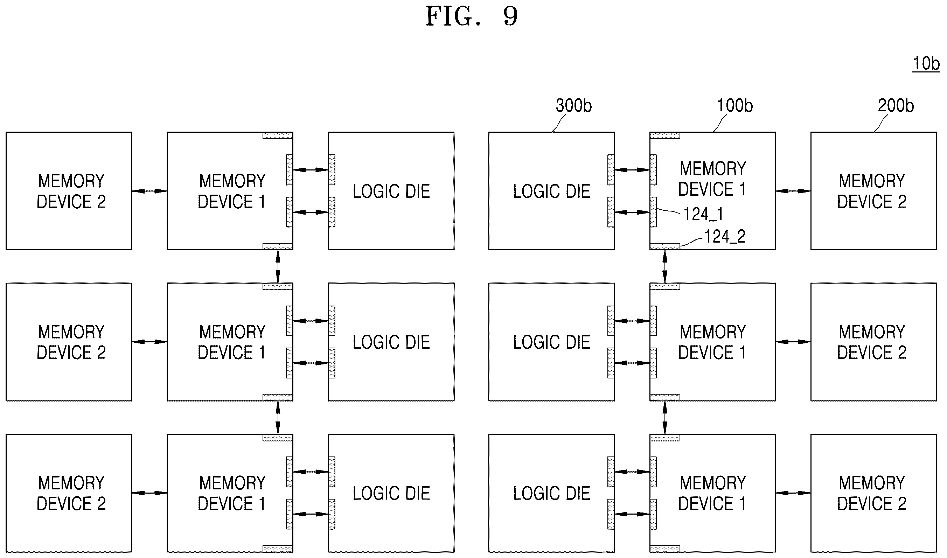

FIG. 9 is a diagram of a system 10b according to one or more embodiments. FIG. 9 may be described with reference to FIGS. 1 through 8, and duplicate descriptions thereof may be omitted.

Referring to FIG. 9, the system 10b may include a plurality of logic dies 300b, a plurality of first memory devices 100b, and a plurality of second memory devices 200b.

As components of the system 10b of FIG. 9, six logic dies 300b, six first memory devices 100b, and six second memory devices 200b are illustrated, but this is only an example, and the numbers of components may be less than or greater than these numbers.

Each of the plurality of logic dies 300b may correspond to the logic die 300 in FIG. 1. Each of the plurality of first memory device 100b may correspond to the first memory device 100 in FIG. 1. Each of the plurality of second memory devices 200b may correspond to the second memory device 200 in FIG. 1.

In the embodiment, the plurality of first memory device 100b may include HBM, and the plurality of second memory device 200b may include DDR RAM, LPDDR RAM, or GDDR RAM.

In the embodiment, the plurality of first memory devices 100b may include HBM, and the plurality of second memory devices 200b may also include HBM. In this case, the plurality of first memory devices 100b may include the base die 120 in FIG. 1 as a component, and may include custom HBM not satisfying JEDEC standard specification in performing communication respectively with the plurality of logic dies 300b. The plurality of second memory devices 200b may include HBM communicating respectively with the plurality of first memory devices 100b according to the JEDEC standard specification.

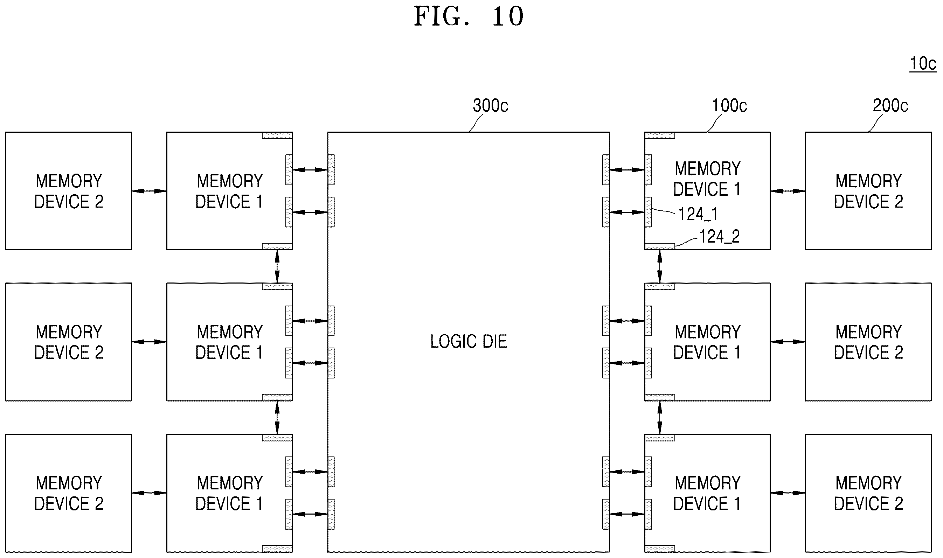

FIG. 10 is a diagram of a system 10c according to one or more embodiments. FIG. 10 may be described with reference to FIGS. 1 through 9, and duplicate descriptions thereof may be omitted.

Referring to FIG. 10, the system 10c may include a logic die 300c, a plurality of first memory devices 100c, and a plurality of second memory devices 200c.

The logic die 300c may correspond to the logic die 300 in FIG. 1. Each of the plurality of first memory devices 100c may correspond to the first memory device 100 in FIG. 1. Each of the plurality of second memory devices 200c may correspond to the second memory device 200 in FIG. 1.

The system 10c of FIG. 10 may be similar to the system 10b of FIG. 9, but unlike the system 10b of FIG. 9 which includes the plurality of logic dies 300b, the system 10c of FIG. 10 may include only one logic die 300c. The logic die 300c of the system 10c of FIG. 10 may be designed in a structure to communicate with the plurality of first memory devices 100c and the plurality of second memory devices 200c.

FIG. 11 is a diagram of a system 1000 according to one or more embodiments.

FIG. 11 is a block diagram of the system 1000 including heterogeneous memory systems, according to embodiments.

Referring to FIG. 11, the system 1000 may include a camera 1100, a display 1200, an audio processor 1300, a modem 1400, HBMs 1510a and 1510b, DRAMs 1520a and 1520b, flash memory devices 1600a and 1600b, input/output (I/O) devices 1700a and 1700b, and an AP 1800. The system 1000 may be implemented as a laptop computer, a mobile phone, a smartphone, a tablet personal computer (PC), a wearable device, a health care device, or an Internet-of-Things (IoT) device. In addition, the system 1000 may be implemented as a server or a PC.

The camera 1100 may capture a still image or a moving image according to a user's control, and may store or transmit to the display 1200 the captured image/image data. The audio processor 1300 may process audio data included in the flash memory devices 1600a and 1600b or in the content of a network. The modem 1400 may modulate and transmit a signal for transmitting wired/wireless data, and demodulate the modulated signal to restore an original signal at a receiving side. The I/O devices 1700a and 1700b may include devices providing digital inputs and/or output functions such as a universal serial bus (USB) or storage, a digital camera, a secure digital (SD) card, a digital versatile disc (DVD), a network adapter, and a touch screen.

The AP 1800 may include a controller 1810 configured to control all operations of the system 1000, and an interface 1830 configured to transmit or receive data and signal to or from external components. The AP 1800 may control the display 1200 so that a portion of the content stored in the flash memory devices 1600a and 1600b is displayed on the display 1200. When a user input is received via the I/O devices 1700a and 1700b, the AP 1800 may perform a control operation corresponding to the user input. The AP 1800 may include an accelerator block, which is a dedicated circuit for artificial intelligence (AI) data computation, or may include an accelerator chip 1820 that is separated from the AP 1800. The DRAM 1500b may be additionally mounted on the accelerator block or the accelerator chip 1820. An accelerator may be a function block that specializes in performing a particular function of the AP 1800. The accelerator may include a GPU that is a function block specialized in processing graphics data, a NPU that is a block specialized in AI calculation and inference, and a data processing unit (DPU) that is a block specialized in data transmission.

The system 1000 may include a plurality of HBMs 1510a and 1520a, and a plurality of DRAMs 1520a and 1520b. The AP 1800 may correspond to the logic die 300 in FIG. 1, each of the plurality of HBMs 1510a and 1510b may correspond to the first memory device 100 in FIG. 1, and each of the plurality of DRAMs 1520a and 1520b may correspond to the second memory device 200 in FIG. 1.

The plurality of HBMs 1510a and 1510b and the plurality of DRAMs 1520a and 1520b may have relatively less latency and relatively higher bandwidth than the I/O devices 1700a and 1700b and the flash memory devices 1600a and 1600b. The plurality of HBMs 1510a and 1510b and the plurality of DRAMs 1520a and 1520b may be initialized at a time point of power-on of the system 1000, and after an operating system and application data are loaded, may be used as an arbitrary storage location of the operating system and the AP data or as an execution space of various software code.

Addition/subtraction/multiplication/division (four fundamental arithmetic operations), vector calculation, address calculation, or fast Fourier transform (FFT) calculation may be performed in the plurality of HBMs 1510a and 1510b and the plurality of DRAMs 1520a and 1520b. In addition, functions for performing inference may be executed in the plurality of HBMs 1510a and 1510b and the plurality of DRAMs 1520a and 1520b. In this case, the inference may be performed by using a deep learning algorithm using an artificial neural network. The deep learning algorithm may include a training operation of learning a model using various data and the inference operation of recognizing data by using the learned model. As one or more embodiments, image photographed by a user using the camera 1100 may be signal processed to be stored in the HBM 1510b or the DRAM 1520b, an accelerator block or the accelerator chip 1820 may perform AI data calculation for identifying data by using data stored in the HBM 1510b or the DRAM 1520b and functions used for the inference operation.

The system 1000 may include a plurality of storages or a plurality of flash memory devices 1600a and 1600b which have a greater capacity than the plurality of HBMs 1510a and 1510b and the plurality of DRAMs 1520a and 1520b. The accelerator block or the accelerator chip 1820 may perform a training operation and AI data operation by using the flash memory devices 1600a and 1600b. Each of the flash memory devices 1600a and 1600b may include a memory controller 1610 and a flash memory 1620.

While the inventive concept has been particularly shown and described with reference to embodiments thereof, it will be understood that various change in form and details may be made therein without departing from the scope of the following claims.

## Claims

1. A memory device (100) comprising:
a memory die stack (110) comprising a plurality of memory dies (MD_1, ..., MD_N) stacked thereon; and
a base die (120) under the memory die stack (110),
wherein the base die (120) comprises:
a via interface circuit (121) connected to the memory die stack (110);
a die-to-die, D2D, interface circuit (124) connected to a processor (310);
a memory interface circuit (126) connected to an external memory device (200); and
a memory management circuit (123) configured to:
control data migration between the memory die stack (110) and the external memory device (200);
based on access information (AINF) related to first data stored in the memory die stack (110), determine whether to migrate the first data from the memory die stack (110) to the external memory device (200); and
based on an access request from the processor (310) to access second data stored on the external memory device (200), provide the second data to the processor (310).

2. The memory device (100) of claim 1, wherein the memory management circuit (123a) comprises:
a first controller;
a second controller configured to access the memory die stack (110) and the external memory device (100), under control of the first controller; and
an access monitor (123_3a) configured to store the access information (AINF) related to the first data stored in the memory die stack (110).

3. The memory device (100) of claim 2, wherein the memory management circuit (123) is further configured to:
monitor an access pattern for accessing the first data stored in the memory die stack (110), and
store a memory address of the first data and a last access time for the first data as the access information (AINF).

4. The memory device (100) of any preceding claim, wherein the via interface circuit (121) is connected to the plurality of memory dies (MD_1, ..., MD_N) through a plurality of vias penetrating the plurality of memory dies (MD_1, ..., MD_N) in a vertical direction.

5. The memory device (100) of any preceding claim, further comprising an interconnect circuit (127) connected to the D2D interface circuit (124), the memory interface circuit (126), and the memory management circuit (123).

6. The memory device (100) of any preceding claim, further comprising a first memory controller (122) configured to write data to the memory die stack (110) or read data stored in the memory die stack (110), based on a request from the processor (310),
wherein the first memory controller (122) is further configured to be connected to the via interface circuit (121).

7. The memory device (100) of any preceding claim, further comprising a second memory controller (125) configured to write data on the external memory device (200) or read data stored in the external memory device (200), based on a request from the processor (310),
wherein the second memory controller (125) is connected to the memory interface circuit (126).

8. The memory device (100) of any preceding claim,
wherein the D2D interface circuit (124) is configured to communicate with the processor (310) based on universal chip interconnect express, UCIe, standard specification, and
wherein the memory interface circuit (126) is configured to communicate with the external memory device (200) based on a Joint Electron Device Engineering Council, JEDEC, standard specification.

9. The memory device (100) of any preceding claim,
wherein the access information (AINF) comprises an access elapse time indicating an elapse time since a last access to the first data stored in the memory die stack (110) by the processor (310), and
wherein the memory management circuit (123) is further configured to, based on the access elapse time being equal to or greater than a migration reference value, migrate the first data from the memory die stack (110) to the external memory device (200).

10. The memory device (100) of any preceding claim, wherein the memory management circuit (123) is further configured to, based on a request from the processor (310) to access the second data stored in the external memory device (200), determine whether to migrate the second data from the external memory device (200) to the memory die stack (110).

11. A system (10a) comprising:
a first memory device (100_1a) comprising a first memory die stack (110) configured to store first data and a first base die (120);
a second memory device (100_2a) comprising a second memory die stack configured to store second data and a second base die;
a third memory device (200_1a) configured to store third data and connected to the first base die (120); and
a logic die (300_1a) comprising a host processor (310), connected to the first base die (120), and configured to generate an access request related to the first data, the second data, and the third data,
wherein the first base die (120) comprises:
a via interface circuit (121) connected to the first memory die stack (110);
a first die-to-die, D2D, interface circuit (124_1) connected to the logic die (300_1a);
a second D2D interface circuit (124_2) connected to the second base die;
a memory interface circuit (126) connected to the third memory device (200_1a); and
a memory management circuit (123) configured to control data migration among the first memory die stack (110), the second memory die stack, and the third memory device (200_1a).

12. The system (10a) of claim 11, wherein the first base die (120) is configured to:
based on an access request from the logic die (300_1a) to access the first data, access the first data via the via interface circuit (121),
based on an access request from the logic die (300_1a) to access the second data, access the second data via the second D2D interface circuit (124_2), and
based on an access request from the logic die (300_1a) to access the third data, access the third data via the memory interface circuit (126).

13. The system (10a) of claim 11 or 12, wherein the memory management circuit (123) is further configured to:
based on access information (AINF) related to the first data stored in the first memory die stack (110), migrate the first data to the third memory device (200_1a), and
based on an access request from the logic die (300_1a) to access the third data, determine whether to migrate the third data to the first memory die stack (110).

14. The system (10a) of any of claims 11 to 13,
wherein the first D2D interface circuit (124_1) and the second D2D interface circuit (124_2) are configured to communicate with the logic die (300_1a) based on a universal chip interconnect express, UCIe, standard specification, and
wherein the memory interface circuit (126) is configured to communicate with the third memory device (200_1a) based on a Joint Electron Device Engineering Council, JEDEC, standard specification.

15. The system (10a) of any of claims 11 to 14, wherein each of the first memory die stack (110) and the second memory die stack comprises a plurality of memory dies stacked in a vertical direction.
